# EUROPEAN PATENT SPECIFICATION

(11) **EP 1 665 913 B1**
(45) Date of publication and mention of the grant of the patent: **01.07.2009**
(21) Application number: 04770463.0
(22) Date of filing: 02.09.2004
(51) Int. Cl.: H05K 3/12, H01L 51/40, B41J 3/407, B29C 67/00

(54) **METHOD AND SYSTEM FOR CREATING FINE LINES USING INK JET TECHNOLOGY**
VERFAHREN UND SYSTEM ZUR ERZEUGUNG FEINER LINIEN UNTER VERWENDUNG VON INKJET-TECHNOLOGIE
PROCEDE ET SYSTEME DE CREATION DE LIGNES FINES SUIVANT UNE TECHNIQUE PAR JET D'ENCRE

(30) Priority: 02.09.2003 US 499099 P
(43) Date of publication of application: 07.06.2006
(60) Divisional application: 09159282.4
(73) Proprietor: PIXDRO LTD., 93502 Jerusalem (IL)
(72) Inventor: VRONSKY, Eli, 47212 Ramat Hasharon (IL)
(74) Representative: van Loon, C.J.J.
(86) International application number: PCT/IL2004/000792
(87) International publication number: WO 2005/022969

(56) References cited:
- EP-A- 0 930 641
- WO-A-02/03322
- WO-A-89/05567
- GB-A- 2 382 798
- US-A1- 2002 108 860

## Description

### FIELD OF THE INVENTION

The invention relates to inkjet technology.

### BACKGROUND OF THE INVENTION

In the production of electronic basic structures, such as printed circuit boards, color filters for liquid crystal displays and semiconductors, a technology which is commonly used involves patterned masks similar in principle to those used in lithographic printing for preparation of printing plates.

A substrate is coated with photosensitive material which is then cured by light. The coating is done by simple dipping or by spin coating when the layer is desired to be very thin. Light is then projected on to the photosensitive layer through a mask which was prepared in advance with a desired pattern. The light which is projected on the photosensitive layer cause it to harden or "cure" at the exposed areas. The non-hardened part, not exposed to light, is washed then away, leaving a desired pattern of hardened layer. Owing the miniaturization of circuit boards, or the required optical precision of color filters there is a demand to create lines as thin as 10 micrometers or less. This is achievable by refmed masks and light sources as well as improved curable materials.

The lithographic process is expensive for two reasons:
- a large portion of the photosensitive material is washed out after curing; and
- each pattern requires its own mask which have to be prepared in advance.

In the printing industry inkjet technology is used to eliminate the need of printing plates as ink droplets are placed directly on a substrate without a mask and under digital control. Thus patterns can be created, changed or replaced on the fly.

Thus, an attractive alternative to masks used to print the photosensitive curable material in the electronic industry is to print patterns of such materials using an inkjet mechanism, thus eliminating the need for masks and moreover using only a small quantity of photosensitive material in comparison to lithography. The smaller amount of material is because it is used only where needed and avoids the need to coat the total surface of the substrate. As some curable materials can be rather expensive when mass production is considered, it should be expected that savings using inkjet printing ought to be substantial. WO-A-02 03322 discloses an example of the use of inkjet printing for the formation of electrical conductors on a substrate.

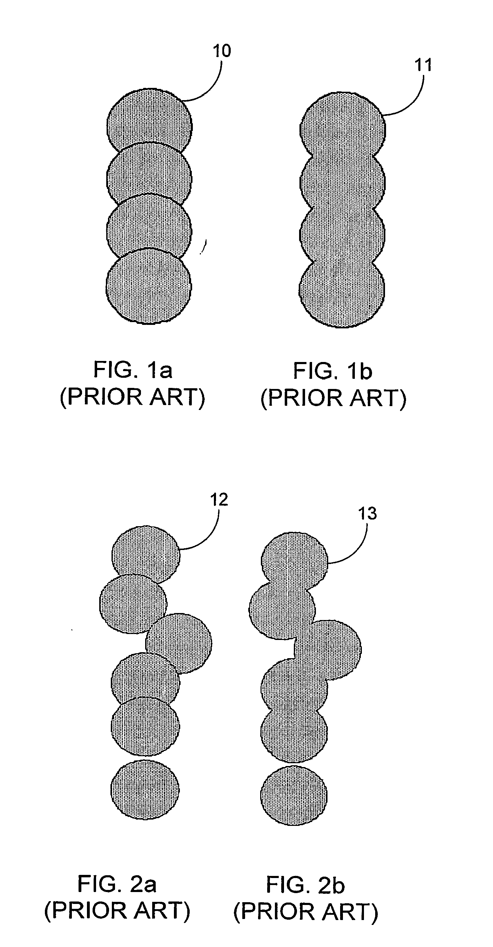

However, printing fine straight lines by inkjet technologies is a complicated task. Fig. la shows a line created using inkjet printing by sequentially juxtaposing ink droplets 10 along a line. Owing to the circular shape that the droplets 10 assume on the substrate, the result on drying as shown in Fig. 1b will be a jagged line 11 that is not as fine as required and has a non-uniform edge.

The reasons for this are multiple:
1. Using even tiny droplets it is very difficult to create lines of less than20µm.
2. Even if such lines could be achieved by inkjet, the effects of surface tension and surface energy of the substrate and local contamination will create unevenness in drop expansion and increase the non-uniformity of the line.
3. When the directionalities of the droplets' placements are slightly out of phase (a common phenomenon in inkjet printers, where directionality is varied by few milliradians at least), the resulting line appears crooked. This is shown in Figs. 2a and 2b, where very minor variations in the directionality of droplets 12, along both X and Y axes contribute to the unevenness of the line edge of the resulting pattern 13.

Furthermore, attempting to use conventional ink-jet techniques, particularly when very thin lines are required, requires expensive, off-line correction of defects such as pin holes which can render a line to be non functional. This, of course, is all the more critical when the lines are used to form electrically conductive tracks in a PCB since such pin holes may be manifested as open circuits.

Owing to the simplicity of ink-jet techniques, their profusion and low-price, it would be a significant benefit if ink-jet technology could be used to produce the fine lines required for the fabrication of electronic devices without being subject to the drawbacks described above.

### SUMMARY OF THE INVENTION

It is therefore an object of the present invention to provide a method for producing the fine lines required for the fabrication of electronic devices using ink-jet technology that are not subject to the drawbacks described above.

This object is realized in accordance with one aspect of the invention by a method for producing a geometry of desired dimension on a substrate, the method comprising:
dropping successive droplets of a material on to the substrate so as to form a pattern; and
characterized by:
the pattern being of sufficient dimension to accommodate said geometry within a boundary thereof; and
removing a redundant area of the pattern that surrounds the portion of said pattern defining said geometry.

The geometry may simply be a fine line and the invention propose two major solutions that enable creation of very fine lines, or any other geometry, of photosensitive curable material.

A first approach employs a hybrid system containing an inkjet printing system and a laser system. The inkjet printing system prints an ink which is curable by light of a predetermined wavelength (for example infrared curable ink from IR laser or UV curable ink with UV laser). The invention proposes three ways of achieving the solution for inkjet deposition of photosensitive curable material which is followed by curing it with light.

According to a second approach, parallel lines of reacting materials are printed, lines or patterns being created at the areas of reaction.

In addition, the invention also provides means to check and repair line defects that might be due to missing or misdirected drops.

### BRIEF DESCRIPTION OF THE DRAWINGS

In order to understand the invention and to see how it may be carried out in practice, a preferred embodiment will now be described, by way of non-limiting example only, with reference to the accompanying drawings, in which:
Figs. 1a and 1b are pictorial representations of a line formed of a series of juxtaposed ink droplets using conventional inkjet technology;
Figs. 2a and 2b are pictorial representations of a line formed of a series of juxtaposed ink droplets when subject to additional distortions inherent in ink-jet technology;
Figs. 3a to 3c are pictorial representations showing successive stages in the formation of lines produced by an inkjet assisted process followed by laser curing;
Figs. 4a to 4g are pictorial representations showing successive stages in the formation of lines produced by an inkjet assisted process followed by etching;
Figs. 5a to 5g are pictorial representations showing successive stages in the formation of lines produced by a lithographic assisted process followed by etching;
Figs. 6 and 7 are pictorial representations of alternative systems according to the invention;
Figs. 8a to 8d and 9a to 9d are pictorial representations showing successive stages in the formation of lines at areas of reaction between parallel lines of reacting materials according to alternative approaches ; and
Figs. 10a to 10d are pictorial representations showing successive stages in the formation of lines produced by ablation of juxtaposed inkjet droplets.

### DETAILED DESCRIPTION OF EXEMPLARY EMBODIMENTS

### Combined use of inkjet printing and of curing by focused laser beam

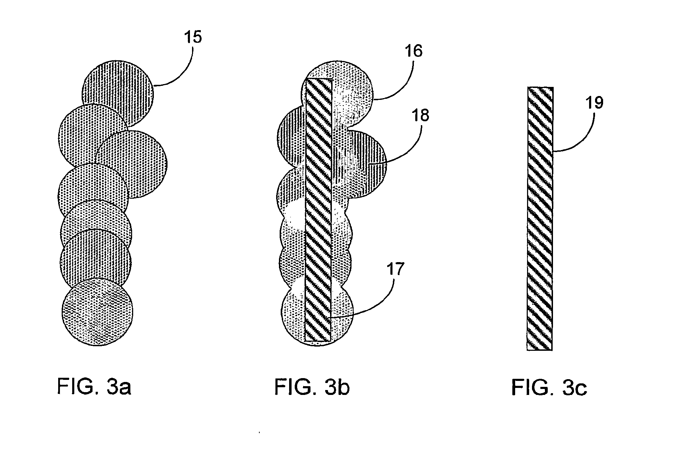

As seen in Figs. 3a and 3b, photosensitive curable material is deposited as a line by inkjet heads containing at least one nozzle. The photosensitive curable material is prepared in advance to have suitable viscosity and surface tension, so it will be easily ejectable and will spread satisfactorily over the substrate.

The inkjet prints a series of juxtaposed ink droplets 15 so as to form a pattern 16 that, with all the distortions as described above with reference to Figs. 1 and 2, leaves sufficient room for a fine line of desired width to be cured within the inked pattern. As shown in Fig. 3b, a laser beam of a desired focus, down to few microns, or in the nanometers range, is moved over the wet ink so as to cure or dry it only in that portion 17 of the pattern 16 where the beam was projected. The surrounding ink residue 18 that is not cured or dried is flushed out so as to leave a fine line 19 with sharp edge on the printed substrate as shown in Fig. 3c.

The laser beam is of a specific wavelength that is known to cure the ink. Some inks are cured by light at the ultraviolet wavelengths, others are cured by light at the infrared wavelength. It is also possible to use inks that are hardened by light at visible wavelengths, but the process will then be complicated by having to be done in the dark.

Such a method can be used for example to print a black matrix for LCD displays where very thin straight lines with width of 10 µm have to be printed. Most manufacturers currently achieve this by lithography. The method according to the invention results in a reduction of the amount of photosensitive curable ink required, printing first inkjet lines which are only several tens of microns wide and having these lines then shaped by laser curing the final straight lines with a required width of 10 µm. The uncured photosensitive material is then flushed out of the substrate by washing.

According to another approach, very fine lines are created using electrically conductive polymers. Currently several companies such as Epson of Japan are trying to construct electronic conductors not with conventional conducting materials but with polymers of high electrical conductivity. Such polymers are ejectable by inkjet mechanisms. Of these polymers, those that are curable and hardened by a precise light source such as a laser can be printed into fine precise lines according to the teaching of the invention. The invention thus paves the way to print conductors with inkjet technology and replace the conventional lithographic techniques.

The same proposed technology of the invention, inkjetting followed by laser curing can be applied to production of Thin Film Transistor (TFT) electronics used in manufacturing of flat panel displays and more generally in other facets of electronic manufacturing. Currently TFT multilayer structures are produced with lithographic techniques that are well-known in the semiconductor manufacturing industry. The lithographic processes are used to create patterns that allow the creation of the complex multilayer structures by selective etching, coating or depositions. The patterns created for those purposes are not only lines but also other geometrical forms. According to the invention, such geometrical forms can be generated by first inkjetting a gross outline, and then bringing them into a final desired form by focused beam laser curing. The operation of the laser beam can be continuous or pulsed, and its movement across the area of the inkjetted curable material can be programmed. This coupled with programmable intensity control of the beam, provides a high degree of flexibility in the creation of desired lines or shapes.

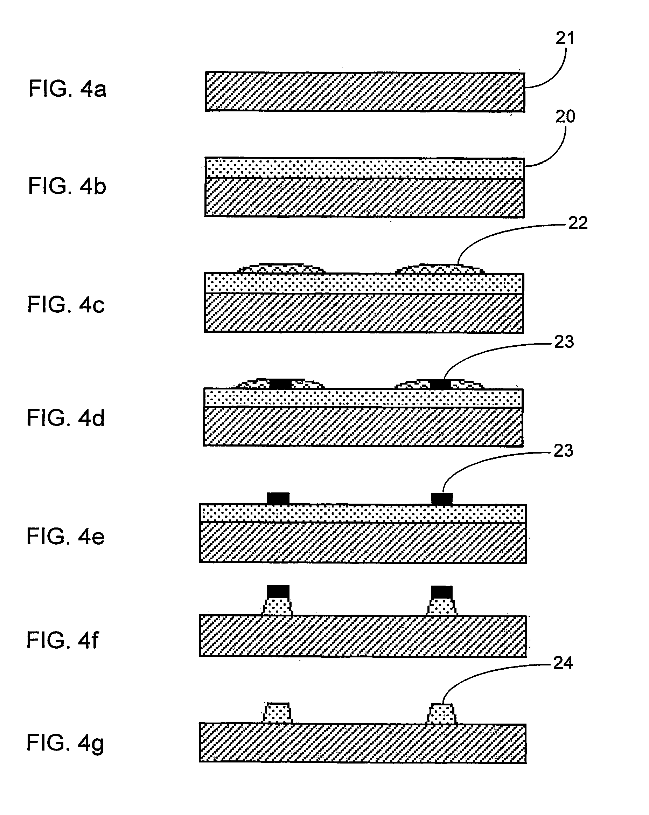

Figs. 4a to 4g are pictorial representations showing successive stages in the formation of lines produced by an inkjet assisted process followed by etching. By such means, it is possible to allow etching of a selective layer within the multilayer structure of a TFT. The figures depict the etching of an "active" layer of such a structure. This active layer might be a conductive material that has to be shaped so that conductivity will be confined only to parts of the layer. The example shows how in successive stages, an active layer 20 is coated on a substrate 21, whereafter inkjetted patterns 22 of photosensitive curable material are formed on the active layer (Fig. 4c). Laser light is focused on the photosensitive curable material so as to expose a pattern of fine lines thereon. Where the laser light strikes the photosensitive curable material, the lines are cured to form the desired patterns 23 (Fig. 4d). The uncured material is then flushed (Fig. 4e) and those areas of the active layer that are not covered by cured material are then etched (Fig. 4e). After etching is completed, the pattern made of the cured material is removed either chemically or using any other suitable method. This process will result in an active layer formed into a precise pattern 24 as shown in Fig. 4g. Those familiar with the art will understand that using the process of the invention will save on photosensitive curable material since there is no need to coat the complete surface of the active layer with photosensitive curable material as is conventionally done. The process of the invention will also simplify removal and cleaning of the photosensitive uncurable material, since there is less of it, and thus be less prone to defects.

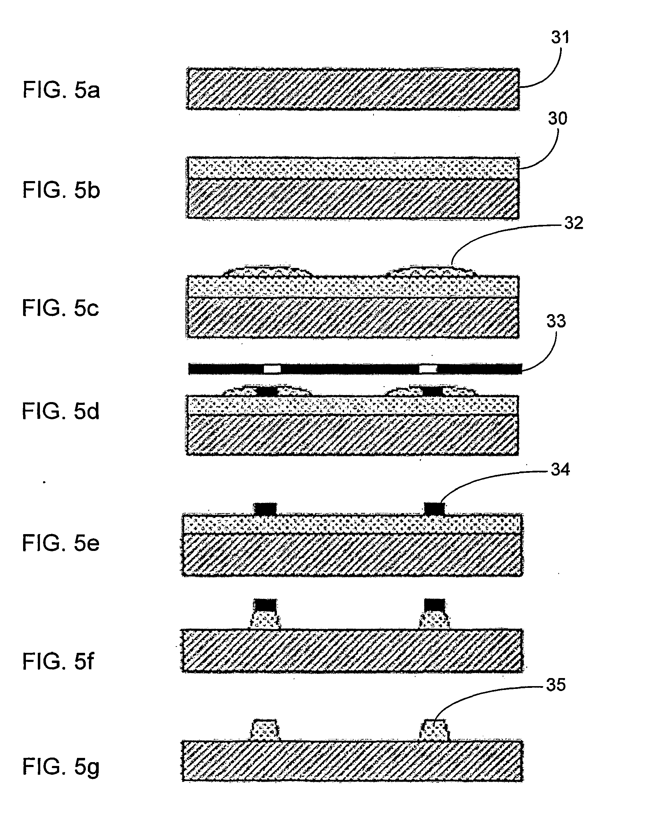

Figs. 5a to 5g are pictorial representations showing successive stages in the same process using lithography. Thus, in successive stages, an active layer 30 is coated on a substrate 31 and layers of photosensitive curable material 32 (Fig. 5c) are applied by an inkjet process. There is no need to coat the entire area of the substrate since it is sufficient that only those areas where lines are to be formed be coated and this lends itself to inkjet printing. By such means, the quantity of photosensitive curable material used may be significantly reduced as compared with conventional lithographic processes where the complete area of the substrate is coated by dipping or spinning. A mask 33 is used to expose a pattern of fine lines on the photosensitive curable material to light so as to cure the desired patterns (Fig. 5d). The uncured areas of the photosensitive curable material 32 are then flushed so as to reveal the pattern of lines 34 (Fig. 5e). Those areas of the active layer that are not covered by cured material are then etched (Fig. 5f). After etching is completed, the pattern made of the cured material is removed either chemically or using any other suitable method. This process will result in an active layer formed into a precise pattern 35 as shown in Fig. 5g.

In addition to the formation of accurate lines, both of these methods are applicable to other geometric forms which are first delineated as a gap in non-curable, non adhering material, this gap being then printed over with curable material. When the substrate is flushed or washed, only the material in the area of the primary gap will be left on the substrate. Thus, in the context of the description and the appended claims the term "geometry" is used to imply any filled shape that may be regular or irregular. It is also to be noted that the term "line" is used to imply any extent of length that is straight, angled or curved or any combination of these properties.

### Reliability issues

One of the major obstacles in inkjet printing is the nozzle reliability. Nozzle reliability can come in several forms:
- Soft failure (nozzle does not work but can be restored in a maintenance process)
- Hard failure (nozzle is permanently unusable)
- Missed directionality
- Smaller drop volume

Having very thin lines with defects can render them non-functional. In the case of color filters mentioned above used in an offset printing process, even a slight defect in the black matrix cells can result in a mixture of two different colors in an adjacent cell rendering defective the picture element they filter.

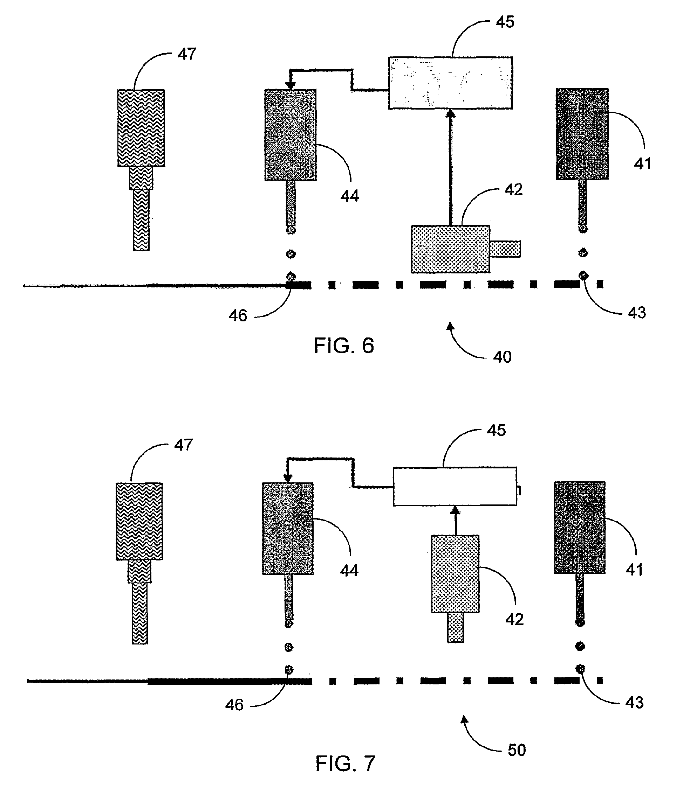

The first method of the invention yields itself to achieving an increased process reliability, correcting to a degree the above mentioned problems. This is achieved by the systems 40 and 50 shown schematically in Figs. 6 and 7, respectively and in which like components are referenced by identical reference numerals. Thus, both systems 40 and 50 include a printing nozzle 41 (constituting a first nozzle), downstream of which there is disposed an optical detector 42, which detects whether the printing nozzle 41 did actually eject a droplet. The detection can be done by looking into the path of the printing nozzle 41 or of a droplet 43 formed thereby as shown in Fig. 6 so as to detect an actual droplet "on the fly", or by looking at the substrate for the actually printed dot as shown in Fig. 7. If the printed dot were not placed or were not placed in the right position, an auxiliary nozzle 44 (constituting a second nozzle) controlled by a controller 45 which is responsively coupled to the optical detector 42 and operates in accordance with a predetermined control algorithm ejects a second droplet 46 to replace or complete the first droplet 43. A laser 47 downstream of the second nozzle 44 cures or dries the printed image according to the desired pattern. The continuity of the process is achieved by the geometry of the correct relative placement of the first nozzle 41, the detector 42, the second nozzle 44 and the laser 47 and relative movement between the substrate and the print system. The droplets may be cured directly after their placement on the substrate or cured after the ink pattern is completely formed.

Another approach is to employ one or more redundant nozzles for printing the pattern so as to increase the probability that the geometry of the desired pattern will appear intact thus providing on the substrate a pattern of sufficient dimension for the laser action. This is a far simpler solution to implement because the exact shape of the inkjetted line is not crucial as long as this line is continuous. The exact shaping may be achieved by the laser curing.

### Creating fine lines by using two materials that are cured by chemical reaction

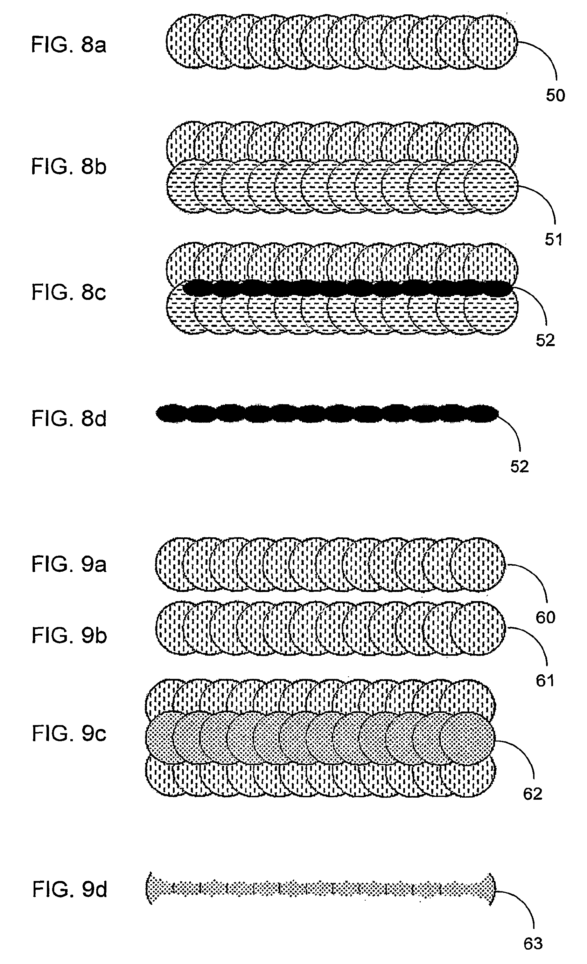

Figs. 8a to 8d are pictorial representations showing successive stages in the formation of lines at areas of reaction between parallel lines of reacting materials according to a first approach. In this method a first line 50 with first material is printed, then a second, parallel, line 51 of second material is printed which overlaps the first line so as to form an overlapping area 52. The first and second lines are formed of materials that react on contact via a chemical or physicochemical reaction that cures the lines where they contact (as in epoxy glues) while having no effect on those areas of the two lines that do not overlap. The reaction is limited therefore to the overlapping area 52 only, and the remains, which are not cured, are flushed after a controlled time (to prevent over curing).

Figs. 9a to 9d are pictorial representations showing successive stages in the formation of lines at areas of reaction between parallel lines of reacting materials according to a second approach. In this method, first and second lines 60 and 61 formed of a first material that may be flushed in known manner are printed on a substrate. A third, parallel, line 62 of a second material is printed which overlaps the first and second lines so as to cover an intervening space 63 between the two lines 60 and 61. The second material is such that in its normal state it cures in air after a known curing time that may be influenced by ambient temperature. Likewise, it may be formed of a material that can be dried or cured in known manner e. g. by light, heat, etc. By such means, the space 63 between the two lines 60 and 61 is filled by the curable second material of the third line 62, which is allowed to cure and adhere to the substrate. The substrate is then washed so as to flush the first and second lines 60 and 61 together with the remaining portions of the third line 62 with which they overlap. It does not matter if the portions of the third line 63 overlapping the two lines 60 and 61 are also allowed to cure providing it remains possible to flush away the first and second lines entirely since, in doing so, the cured portions of the third line will likewise be disposed of.

However, if desired, the second material may be such that on contact with the first material of the first and second lines 60 and 61 it reacts via a chemical or physicochemical reaction that prevents curing of the second material, while having no effect on that area of the third line that does not overlap the first and second lines, i. e. within the space 63. By such means it may be easier to flush away the redundant material.

### Creating fine lines with inkjet by overlapping separate colored inks

This method applied to color filters only and may be used in conjunction with one of the other methods described above to generate many different shapes. This method uses the three primary colors (RGB) to create the black matrix used to separate between the colors. The working process is similar to that described above with reference to Fig. 8.

In the first stage a first RGB color is printed. In a second stage a second RGB color is printed to overlap the first one. Every two colors create a chemical reaction between the overlapping areas such that the overlapping areas are converted to black. In this way the black matrix is created at every border between colors. In a final stage the colors are cured or dried. Such a method may be used in color offset printing, for example in the manufacture of color displays such as LCDs, whereby the three RGB components of each pixel can be printed using an inkjet while ensuring that any overlap is black.

### Combined use of inkjet printing-and of ablation by focused laser beam

The principle described above with reference to Figs. 3a to 3b of first creating a gross line or shape by inkjetting and then tailoring the precise form by laser can also be employed where the laser beam is used to ablate parts of the ink.

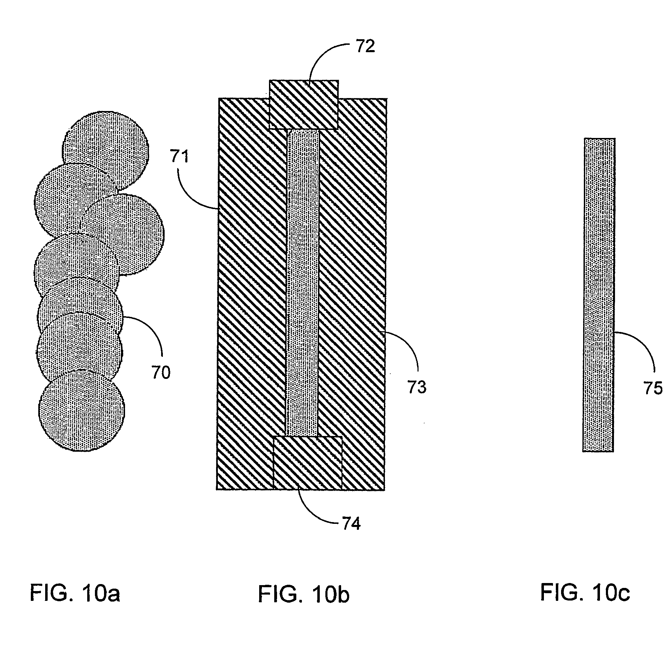

Figs.10a to 10d are pictorial representations showing successive stages in such a process. A line of material 70 which can be ablated by laser beam is printed. A laser beam is used to ablate it on all four sides so as to remove the areas 71, 72, 73 and 74. By such means, what remains on the substrate is a fine and precise line 75 having fine edges and a desired width. An excimer laser, for example can be used to create controlled and precise ablation.

### Other fields where the principles of the invention can be applied

Although the invention has been described with particular regard to the formation of fine lines, it is to be understood that the principles of the invention are applicable to any geometrical shape. For example, while it known to manufacture PCBs using an artwork that defines the circuit pads and conductive tracks and which is typically used as a mask through which the active layer of the PCB is exposed to light, the invention allows the artwork to be drawn directly on the PCB thus avoiding the need for a mask. In such an approach the active layer (typically copper) is first covered with photosensitive curable material so that the exposed portions are cured. The uncured material is then flushed thus exposing all those areas of the active copper layer that are redundant, allowing these to be etched without affecting those areas of the active copper layer that are to be preserved. In such an approach much of the active layer is disposed of.

However, the principles of the invention allow the copper tracks and pads (i.e. artwork) to be drawn directly on to an insulating substrate using an electrically conductive ink that is applied using inkjet technology, allowing surplus ink to be removed either by curing those areas that are to be preserved and flushing the remainder; or by ablating the redundant areas either prior to or subsequent to curing the remaining material. Such an approach requires far less surplus conductive material to be removed.

## Claims

1. A method for producing a geometry (24, 35) of desired dimension on a substrate, the method comprising:
dropping successive droplets (43) of a material on to the substrate so as to form a pattern (22, 32),
**characterized in that:**
the pattern (22, 32) is of sufficient dimension to accommodate said geometry within a boundary thereof; and
removing a redundant area of the pattern that surrounds the portion of said pattern defining said geometry.

2. The method according claim 1, wherein the redundant area of the pattern is removed by: curing an area of the pattern that defines said geometry; and removing all material that is not cured.

3. The method according to claim 2, wherein the geometry is cured using a laser beam.

4. The method according to claim 2 or 3, wherein the droplets are cured directly after their placement on the substrate.

5. The method according to claim 2 or 3, wherein the droplets are cured after the ink pattern is completely formed.

6. The method according claim 1, wherein the redundant area of the pattern is removed by: ablating at least one redundant area (71, 72, 73, 74) of the pattern that surrounds said geometry (75).

7. The method according claim 6, wherein a laser is used to create controlled and precise ablation.

8. The method according claim 6 or 7, further including curing an area of the pattern that defines said geometry.

9. The method according to any one of the preceding claims, further including monitoring the droplets and perfecting a missing or incompletely formed droplet.

10. The method according to claim 9, wherein said perfecting is effected by one or more auxiliary inkjet printer heads.

11. The method according to any one of claims 1 to 8, further including duplicating some of said droplets so as to reduce the likelihood of a missing or incompletely formed droplet.

12. The method according to claim 11, wherein said duplicating is effected by one or more auxiliary inkjet printer heads.

13. The method according to any one of claims 1 to 12, wherein the material is ink.

14. The method according to any one of claims 1 to 13, wherein the material is applied only to discrete areas of the substrate that are each sufficient to accommodate one or more lines within their respective boundaries.

15. The method according to any one of claims 1 to 13, wherein the material is a photosensitive curable material.

16. The method according to claim 15, further including: exposing the photosensitive curable material to light via a mask so as to cure the material corresponding to said geometry.

17. The method according to claim 15, wherein the photosensitive curable material (32) is applied to an active layer (30) on a substrate(31), there being further included:
exposing the photosensitive curable material to light via a mask so as to cure the material corresponding to said geometry;
flushing the uncured areas of the photosensitive curable material (32) so as to reveal the geometry (34);
etching those areas of the active layer that are not covered by cured material; and
removing the pattern made of the cured material.

18. The method according to claim 16 or 17, wherein the photosensitive curable material is applied only to discrete areas of the active layer on said substrate that are each sufficient to accommodate one or more geometries within their respective boundaries.

19. The method according to any one of claims 1 to 16, including:
inkjet printing a first geometry (50) with first material,
inkjet printing a second, substantially parallel, geometry (51) of second material so as to overlap the first geometry so as to form an overlapping area (52);
the first and second geometries being formed of materials that react on contact so as to cures the geometries where they contact while having no effect on those areas of the two geometries that do not overlap; and
flushing the first and second materials that have not cured.

20. The method according to any one of claims 1 to 16, including:
inkjet printing substantially parallel non-contiguous first and second geometries (60) and (61) formed of a first material that may be flushed from the substrate;
inkjet printing a third, substantially parallel, geometry (62) formed of a second material so as to overlap the first and second lines so as to cover an intervening space (63) between the first and second lines (60, 61);
curing the second material in the space (63) between the first and second geometries (60, 61) so that it adheres to the substrate; and
washing the substrate so as to flush the first and second geometries (60, 61) together with remaining portions of the third geometry (62) with which they overlap.

21. The method according to any one of claims 1 to 15, including:
inkjet printing a first area with first material to form a first primary color,
inkjet printing a second area with a second material to form a second primary color so as to overlap the first primary color so as to form an overlapping area;
the first and second materials being such that they react on contact so as to turn black.

22. The method according to claim 1, wherein, for producing a fine line of desired width on a substrate:
the successive droplets are of an ablatable material and the pattern (70) is of sufficient dimension to accommodate within the boundary thereof a line (75) of said desired width; and
the removing of the redundant area (71, 72, 73, 74) of the pattern that surrounds said line is ablating.

## Patentansprüche

1. Verfahren zur Herstellung eines geometrischen Gebildes (24, 35) mit gewünschten Abmessungen auf einem Substrat, wobei das Verfahren umfasst:
sukzessives Tropfen von Tröpfchen (43) eines Materials auf das Substrat, um so ein Muster (22, 32) zu bilden,
**dadurch gekennzeichnet, dass**
das Muster (22, 32) ausreichende Abmessungen hat, um das geometrische Gebilde innerhalb einer Grenze desselben aufnehmen zu können, und
Entfernen eines redundanten Bereichs des Musters, der den Teil des Musters umgibt, der das geometrische Gebilde definiert.

2. Verfahren gemäß Anspruch 1, wobei der redundante Bereich des Musters entfernt wird durch: Härten eines Bereichs des Musters, der das geometrische Gebilde definiert, und Entfernen des gesamten Materials, das nicht gehärtet ist.

3. Verfahren gemäß Anspruch 2, wobei das geometrische Gebilde unter Verwendung eines Laserstrahls gehärtet wird.

4. Verfahren gemäß Anspruch 2 oder 3, wobei die Tröpfchen direkt nach ihrer Platzierung auf dem Substrat gehärtet werden.

5. Verfahren gemäß Anspruch 2 oder 3, wobei die Tröpfchen gehärtet werden, nachdem das Tintenmuster vollständig ausgebildet ist.

6. Verfahren gemäß Anspruch 1, wobei der redundante Bereich des Musters entfernt wird durch: Ablatieren wenigstens eines redundanten Bereichs (71, 72, 73, 74) des Musters, der das geometrische Gebilde (75) umgibt.

7. Verfahren gemäß Anspruch 6, wobei ein Laser verwendet wird, um eine kontrollierte und genaue Ablation durchzuführen.

8. Verfahren gemäß Anspruch 6 oder 7, das außerdem Härten eines Bereichs des Musters, der das geometrische Gebilde definiert, umfasst.

9. Verfahren gemäß einem der vorangehenden Ansprüche, das außerdem ein Überwachen der Tröpfchen und ein Einfügen bzw. Vervollständigen eines fehlenden oder unvollständig ausgebildeten Tröpfchens umfasst.

10. Verfahren gemäß Anspruch 9, wobei das Vervollständigen durch einen Hilfs-Tintenstrahldruckerkopf oder mehrere Hilfs-Tintenstrahldruckerköpfe durchgeführt wird.

11. Verfahren gemäß einem der Ansprüche 1 bis 8, das außerdem ein Duplizieren einiger der Tröpfchen umfasst, um so die Wahrscheinlichkeit für ein fehlendes oder unvollständig ausgebildetes Tröpfchen zu verringern.

12. Verfahren gemäß Anspruch 11, wobei das Duplizieren durch einen Hilfs-Tintenstrahldruckerkopf oder mehrere Hilfs-Tintenstrahldruckerköpfe durchgeführt wird.

13. Verfahren gemäß einem der Ansprüche 1 bis 12, wobei das Material Tinte ist.

14. Verfahren gemäß einem der Ansprüche 1 bis 13, wobei das Material nur auf diskrete Bereiche des Substrats aufgetragen wird, die jeweils ausreichend sind, um eine oder mehrere Linie(n) in ihren entsprechenden Grenzen aufzunehmen.

15. Verfahren gemäß einem der Ansprüche 1 bis 13, wobei das Material ein lichtempfindliches härtbares Material ist.

16. Verfahren gemäß Anspruch 15, außerdem umfassend:
Belichten des lichtempfindlichen härtbaren Materials mit Licht durch eine Maske, um so das Material entsprechend dem geometrischen Gebilde zu härten.

17. Verfahren gemäß Anspruch 15, wobei das lichtempfindliche härtbare Material (32) auf eine aktive Schicht (30) auf einem Substrat (31) aufgetragen wird, wobei es außerdem umfasst:
Belichten des lichtempfindlichen härtbaren Materials mit Licht mittels Maske, um so das Material entsprechend dem geometrischen Gebilde zu härten;
Wegspülen der ungehärteten Bereiche des lichtempfindlichen härtbaren Materials (32), um so das geometrische Gebilde (34) freizulegen;
Ätzen solcher Bereiche der aktiven Schicht, die nicht von gehärtetem Material bedeckt sind, und
Entfernen des aus dem gehärteten Material hergestellten Muster.

18. Verfahren gemäß Anspruch 16 oder 17, wobei das lichtempfindliche härtbare Material nur auf diskrete Bereiche der aktiven Schicht auf dem Substrat aufgetragen wird, welche ausreichend sind, um ein geometrisches Gebilde oder mehrere geometrische Gebilde in ihren jeweiligen Grenzen aufzunehmen.

19. Verfahren gemäß einem der Ansprüche 1 bis 16, umfassend:
Tintenstrahldrucken eines ersten geometrischen Gebildes (50) mit erstem Material,
Tintenstrahldrucken eines zweiten, im Wesentlichen parallelen geometrischen Gebildes (51) aus zweitem Material, sodass es das erste geometrische Gebilde unter Bildung eines Überlappungsbereichs (52) überlappt;
wobei das erste und zweite geometrische Gebilde aus Materialien gebildet sind, die bei Kontakt reagieren, um so die geometrischen Gebilde zu härten, wo sie miteinander in Kontakt kommen, während sie keinen Effekt auf solche Bereiche der zwei Geometrien haben, die sich nicht überlappen, und
Wegspülen des ersten und zweiten Materials, die nicht gehärtet wurden.

20. Verfahren gemäß einem der Ansprüche 1 bis 16, umfassend:
Tintenstrahldrucken im Wesentlichen paralleler sich nicht berührender erster und zweiter geometrischer Gebilde (60) und (61), die aus einem ersten Material gebildet sind, das vom Substrat weggespült werden kann;
Tintenstrahldrucken eines dritten, im Wesentlichen parallelen geometrischen Gebildes (62), das aus einem zweiten Material gebildet ist, derart, dass die erste und zweite Linie überlappen, um so einen Zwischenraum (63) zwischen der ersten und der zweiten Linie (60, 61) zu bedecken;
Härten des zweiten Materials in dem Raum (63) zwischen dem ersten und zweiten geometrischen Gebilde (60, 61), sodass es an dem Substrat haftet, und
Waschen des Substrats, um so das erste und zweite geometrische Gebilde (60, 61) zusammen mit den verbleibenden Teilen des dritten geometrischen Gebildes (62), mit dem sie überlappen, wegzuspülen.

21. Verfahren gemäß einem der Ansprüche 1 bis 15, umfassend:
Tintenstrahldrucken eines ersten Bereichs mit erstem Material unter Bildung einer ersten Primärfarbe,
Tintenstrahldrucken eines zweiten Bereichs mit einem zweiten Material unter Bildung einer zweiten Primärfarbe, um so die erste Primärfarbe zu überlappen, um einen Überlappungsbereich zu bilden;
wobei das erste und zweite Material so sind, dass sie bei Kontakt unter Farbänderung nach schwarz reagieren.

22. Verfahren gemäß Anspruch 1, indem zur Herstellung einer feinen Linie einer gewünschten Breite auf dem Substrat:
die sukzessiven Tröpfchen aus einem abtragbaren bzw. abschmelzbaren Material sind und das Muster ausreichende Abmessungen hat, um innerhalb der Grenze desselben eine Linie (75) der gewünschten Breite aufzunehmen, und
die Entfernung des redundanten Bereichs (71, 72, 73, 74) des Musters, das die Linie umgibt, durch Ablation erfolgt.

## Revendications

1. Procédé pour produire une géométrie (24, 35) de dimension souhaitée sur un substrat, le procédé comprenant :
l'écoulement successive de gouttelettes (43) d'une matière sur le substrat, de manière à former un motif (22, 32),
**caractérisé en ce que :**
le motif (22, 32) est de dimensions suffisantes pour loger ladite géométrie dans une limite de celui-ci ; et
l'enlèvement d'une zone redondante du motif, qui entoure la partie dudit motif, définissant ladite géométrie.

2. Procédé selon la revendication 1, dans lequel la zone redondante du motif est supprimée par : réticulation d'une zone du motif qui définit ladite géométrie ; et suppression de la totalité de la matière n'ayant pas été réticulée.

3. Procédé selon la revendication 2, dans lequel la géométrie est réticulée en utilisant un faisceau laser.

4. Procédé selon la revendication 2 ou 3, dans lequel les gouttelettes sont réticulées directement après leur placement sur le substrat.

5. Procédé selon la revendication 2 ou 3, dans lequel les gouttelettes sont réticulées après que le motif d'encre ait été complètement formé.

6. Procédé selon la revendication 1, dans lequel la zone redondante du motif est enlevée par : ablation d'au moins une zone redondante (71, 72, 73, 74) du motif qui entoure ladite géométrie (75).

7. Procédé selon la revendication 6, dans lequel un laser est utilisé pour créer une ablation contrôlée et précise.

8. Procédé selon la revendication 6 ou 7, comprenant en outre la réticulation d'une zone du motif qui définit ladite géométrie.

9. Procédé selon l'une quelconque des revendications précédentes, comprenant en outre la surveillance des gouttelettes et le perfectionnement d'une gouttelette manquante ou incomplètement formée.

10. Procédé selon la revendication 9, dans lequel ledit perfectionnement est effectué par une ou plusieurs têtes d'imprimante à jet d'encre auxiliaire.

11. Procédé selon l'une quelconque des revendications 1 à 8, comprenant en outre la duplication de certaines desdites gouttelettes de manière à réduire la probabilité d'une gouttelette manquante ou incomplètement formée.

12. Procédé selon la revendication 11, dans lequel ladite duplication est effectuée par une ou plusieurs têtes d'imprimante à jet d'encre auxiliaire.

13. Procédé selon l'une quelconque des revendications 1 à 12, dans lequel la matière est de l'encre.

14. Procédé selon l'une quelconque des revendications 1 à 13, dans lequel la matière est appliquée uniquement sur des zones distinctes du substrat qui sont chacune suffisantes pour loger une ou plusieurs lignes, dans leurs limites respectives.

15. Procédé selon l'une quelconque des revendications 1 à 13, dans lequel la matière est une matière réticulable photosensible.

16. Procédé selon la revendication 15, comprenant en outre : l'exposition de la matière réticulable photosensible à la lumière, via un masque, de manière à réticuler la matière correspondant à ladite géométrie.

17. Procédé selon la revendication 15, dans lequel la matière réticulable photosensible (32) est appliquée sur une couche (30) active sur un substrat (31), étant en outre inclus :
l'exposition du matériau réticulable photosensible à la lumière, via un masque, de manière à réticuler la matière correspondante à ladite géométrie ;
l'enlèvement par rinçage des zones non réticulées de la matière réticulable photosensible (32), de manière à révéler la géométrie (34) ;
la gravure des zones de la couche active qui ne sont pas couvertes par la matière réticulée ; et
l'enlèvement du motif composé de la matière réticulée.

18. Procédé selon la revendication 16 ou 17, dans lequel la matière réticulable photosensible est appliquée uniquement sur les zones distinctes de la couche active, sur ledit substrat, qui sont chacune suffisantes pour loger une ou plusieurs géométries à l'intérieur de leurs limites respectives

19. Procédé selon l'une quelconque des revendications 1 à 16, comprenant :
l'impression par jet d'encre d'une première géométrie (50) avec une première matière,
l'impression par jet d'encre, sensiblement parallèle, d'une deuxième géométrie (51) d'une deuxième matière, de manière à chevaucher la première géométrie pour former une zone de chevauchement (52) ;
les première et deuxième géométries étant formées de matières réagissant au contact, de manière à réticuler les géométries là où elles sont en contact, tandis qu'il n'y a aucun effet sur les zones des deux géométries qui ne se chevauchent pas ; et
l'enlèvement par rinçage des première et deuxième matières n'ayant pas été réticulée.

20. Procédé selon l'une quelconque des revendications 1 à 16, comprenant :
l'impression par jet d'encre de première et deuxième géométries (60) et (61) non contiguës, sensiblement parallèles, formées d'une première matière pouvant être enlevée par rinçage du substrat ;
l'impression par jet d'encre d'une troisième géométrie (62), sensiblement parallèle, formée par une deuxième matière, de manière à chevaucher les première et deuxième lignes, pour couvrir un espace d'intervention (63) entre les première et deuxième lignes (60, 61) ;
la réticulation de la deuxième matière se trouvant dans l'espace (63) entre les première et deuxième géométries (60, 61), de manière qu'elle adhère au substrat ; et
le lavage du substrat, de manière à enlever par rinçage les première et deuxième géométries (60, 61), conjointement avec les parties restantes de la troisième géométrie (62), avec laquelle elles sont en chevauchement.

21. Procédé selon l'une quelconque des revendications 1 à 15, comprenant :
l'impression par jet d'encre d'une première zone avec une première matière, pour former une première couleur primaire ;
l'impression par jet d'encre d'une deuxième zone avec une deuxième matière, pour former une deuxième couleur primaire, de manière à chevaucher la première couleur primaire pour former une zone de chevauchement ;
les première et deuxième matières étant tels qu'elles réagissent lors du contact, de manière à virer au noir.

22. Procédé selon la revendication 1, dans lequel, pour produire une ligne fine de largeur souhaitée sur un substrat :
les gouttelettes successives sont composée d'une matière susceptible d'être soumise à une ablation et le motif (70) est d'une dimension suffisante pour loger, à l'intérieur de sa limite, une ligne (75) de ladite largeur souhaitée ; et
l'enlèvement de la zone redondante (71, 72, 73, 74) du motif qui entoure ladite ligne se fait par ablation.
